# EUROPEAN PATENT APPLICATION

(11) **EP 4 650 870 A2**
(43) Date of publication of application: **19.11.2025**
(21) Application number: 25174600.4
(22) Date of filing: 06.05.2025
(51) Int. Cl.: G03F 1/32, G03F 1/80

(54) **PHOTOMASK BLANK, AND METHOD FOR MANUFACTURING PHOTOMASK**

(30) Priority: 17.05.2024 JP 2024080620
(71) Applicant: SHIN-ETSU CHEMICAL CO., LTD.,, Chiyoda-ku, Tokyo 1000005 (JP)
(72) Inventor: MIYAJIMA, Chiaki, Joetsu-shi, 9428601 (JP)
(74) Representative: Mewburn Ellis LLP

(57) **Abstract**

A photomask blank including a transparent substrate, a film composed of a material containing chromium, and a film composed of a material containing tantalum is provided. The film composed of a material containing tantalum is constituted of a single layer or multiple layers, and has a thickness of 0.5 to 15 nm; the material containing tantalum contains tantalum, and oxygen or oxygen and nitrogen, and is free of silicon; the single layer and at least the layer remotest from the transparent substrate among the layers constituting the multiple layers are composed of a material containing tantalum that has a tantalum content of 40 to 80 at%, an oxygen content of 5 to 50 at%, and a nitrogen content of not more than 50 at%; and the layer remotest from the transparent substrate has a thickness of not less than 0.5 nm.

## Description

### TECHNICAL FIELD

The present invention relates to a method for manufacturing a photomask that is used in manufacturing semiconductor devices and others, and a photomask blank that is used as a material for manufacturing the reflective photomask.

### BACKGROUND

Recently, it is required that projection exposure has high pattern resolution in accordance with miniaturization of semiconductor devices, particularly, in accordance with high integration of large-scale integrated circuits. So, as a photomask, a phase shift mask has been developed as a means for improving the resolution of a transfer pattern. A principle of phase shift method is that, by adjusting so as to invert a phase of transmitted light that has been passed through an opening of a phase shift film by about 180 degrees with respect to a phase of transmitted light that has been passed through the portion adjacent to the opening, interference between the transmitted lights reduces a light intensity at the boundary of the opening and the portion adjacent to the opening. As a result, resolution of a transfer pattern and depth of focus are improved. A photomask utilizing this principle is generally called a phase shift mask.

A most common phase shift mask blank that is used for manufacturing a phase shift mask has a structure in which a phase shift film is laminated on a transparent substrate such as a glass substrate, and a film composed of a material containing chromium are laminated on the phase shift film. The phase shift film usually has a phase shift of about 175 to 185 degrees and a transmittance of about 6 to 30% with respect to exposure light. A mainstream phase shift film is a film composed of a material containing molybdenum and silicon. Further, a film composed of a material containing chromium is adjusted so as to have a thickness that provides a prescribed optical density together with the phase shift film, and the film composed of a material containing chromium is generally used as a light-shielding film, and is also utilized as a hard mask to etch the phase shift film.

As a method for forming a pattern of the phase shift film from such a phase shift mask blank, the following method is exemplified. First, a resist film is formed on the film composed of a material containing chromium of the phase shift mask blank, a resist film pattern is formed by drawing a pattern onto the resist film by light or an electron beam, and developing, and the film composed of a material containing chromium is etched with using the resist film pattern as an etching mask to form a pattern of the film composed of a material containing chromium. Further, the phase shift film is etched with using the pattern of the film composed of a material containing chromium as an etching mask to form a pattern of the phase shift film, then, the resist film pattern and the film composed of a material containing chromium are removed in sequence.

Further, the film composed of a material containing chromium is remained as a light-shielding film at the portion outside of the portion in which a circuit pattern of the phase shift film is formed, and a light-shielding portion (light-shielding pattern) having an optical density of not less than 3 in the combination of the phase shift film and the light-shielding film is provided at the outer periphery portion of the phase shift mask. This is to prevent irradiation of exposure light caused by transmitting the exposure light that is insufficient light-shielded at the outer periphery portion of the phase shift mask to the resist film adjacent the portion to exposure the circuit pattern in transferring the circuit pattern to a resist film on a wafer with using a wafer exposure device. In a general method for forming such a light-shielding film pattern, after forming a pattern of the phase shift film and removing a resist film pattern, a resist film is anew formed and a resist film pattern is formed by drawing a pattern by light or an electron beam and developing. Then, a film composed of a material containing chromium is etched only in the circuit pattern portion with using the resist film pattern as an etching mask to form the light-shielding portion (light-shielding film pattern) remained on the outer periphery portion.

A mainstream etching for manufacturing a photomask that requires pattern formation with highly accurate is dry etching using gas plasma. Dry etching using a chlorine-based gas is used as dry etching for a film composed of a material containing chromium, and dry etching using a fluorine-based gas is used as dry etching for a film containing molybdenum and silicon. Particularly, it is known that, in dry etching for a film composed of a material containing chromium, chemical reactivity and etching rate are increased by applying an etching gas of chlorine gas (Cl₂ gas) mixed with 10 to 25 vol% of oxygen gas (O₂ gas) as a chlorine-based gas being an etching gas.

According to miniaturization of circuit patterns, a phase shift mask pattern also requires a technique for fine pattern formation. Particularly, assist patterns of line patterns, which assist resolution of main patterns of the phase shift mask, are needed to be formed smaller than the main patterns so as not to be transferred onto a resist film on a wafer when circuit patterns are transferred onto the resist film of the wafer with using a wafer exposure device. In a phase shift mask of a generation in which a pitch of line and space patterns of the circuit on the wafer is 10 nm or narrower, a line width of the assist patterns of the line patterns on the phase shift mask is required to be about 40 nm. In this case, to stably manufacture a phase shift mask having a highly accurate circuit pattern with a margin for variation, the line width needs to be narrower than about 40 nm, and the line width of the assist pattern is required to be about 36 nm.

To manufacture a phase shift mask having fine patterns, a chemically amplified resist is generally used as a resist. A chemically amplified resist consists of a base resin, an acid generator, a surfactant and others, and can be applied to many reactions in which the acid generated by exposure acts as a catalyst, thus, the chemically amplified resist can have high sensitivity. The chemically amplified resist can form a film pattern such as a phase shift film pattern having a line width of not more than 0.2 µm. However, even in the case of a chemically amplified resist, when the pattern width is narrowed, the resist film pattern collapses due to impact of a developing solution in development process or impact of pure water during rinsing, eventually resulting in resolution limit.

A general thickness of the resist film used for manufacturing a phase shift mask is about 100 to 150 nm. However, it is difficult to form a finer assist pattern in a phase shift mask by such a thickness. The reason is that since a thick resist film formed on a film composed of material containing chromium has a high height-to-width ratio (aspect ratio) in the resist film pattern for forming the assist pattern having a narrow line width, in developing process for forming the resist film pattern, the resist film pattern collapses due to impact of a developing solution or impact of pure water during rinsing.

When reduction of the height-to-width ratio (aspect ratio) of the resist film pattern is considered for reducing influence of the impact of the developing solution or the impact of pure water in rinsing, it is necessary to further thin the resist film. However, when the resist film is thin, if the resist film is lost during dry etching of the film composed of a material containing chromium, pinhole defects are formed in the film composed of the material containing chromium. As a result, when a phase shift film is dry-etched with using, as an etching mask, a pattern of the film composed of a material containing chromium in which pinhole defects have been formed, in etching of the phase shift film, plasma reaches to the phase shift film through the pinholes, pinhole defects are formed also in the phase shift film. In this case, a normal phase shift mask cannot be manufactured.

So, to solve this problem, it has been considered that a film composed of a material containing silicon has been further provided on the film composed of a material containing chromium to use as a hard mask film. In this case, the film composed of a material containing silicon is a thin film having a thickness of 5 to 15 nm, and a thickness of the resist film formed on the film composed of a material containing silicon can be thinned with a thickness of about 80 to 110 nm.

In the case that the film composed of a material containing chromium is dry-etched with using a chlorine-based gas containing oxygen, the etching must be performed for an etching-clear-time that is a time for which the film composed of a material containing chromium disappears, with adding an over-etching that is 100 to 300% of the etching-clear-time. This is because dry etching using the oxygen-containing chlorine-based gas is isotropic etching dominated by chemical components. Therefore, a desired pattern width is not stably formed since a pattern of the film composed of a material containing chromium is insufficiently etched at the boundary with the phase shift film, resulting in a trailing shape by dry etching only for the etching-clear-time.

Further, since the dry etching using a chlorine-based gas containing oxygen is isotropic etching dominated by chemical components, plasma of the chlorine-based gas containing oxygen moves in vertical and horizontal directions to the main surface of the substrate, resulting in side etching in the pattern of the film composed of a material containing chromium. Thus, to obtain uniform CD (Critical Dimension), which is a pattern line width, over the entire surface of the mask, it is necessary to obtain the same amount of side etching over the entire surface of the mask. For this purpose, long-time over-etching is required until the amount of side etching saturates (reaches to saturated state) over the entire surface of the mask, and stabilizes.

Dry etching using a fluorine-based is used for dry etching for the film composed of a material containing silicon. In the case that the film composed of a material containing silicon is dry-etched with using a fluorine-based gas, the etching is performed for an etching-clear-time that is a time for which the film composed of a material containing silicon disappears, with adding an over-etching that is up to about 20% of the etching-clear-time (for example, short over-etching of 1 to 6 seconds).

Short-time over-etching can be applied in dry etching using a fluorine-based gas for the film composed of a material containing silicon because the dry etching using a fluorine-based gas is anisotropic etching dominated by physical components, and a trailing shape is not formed to a pattern of the film composed of a material containing silicon at the boundary with the film composed of a material containing chromium. Further, since plasma of the fluorine-based gas moves in vertical direction to the main surface of the substrate, and the CD of the resist film pattern is faithfully duplicated to the pattern of the film composed of a material containing silicon.

Dry etching using a fluorine-based gas is anisotropic etching dominated by physical components, thus, an amount of loss of the resist by the dry etching is generally larger than dry etching using a chlorine-based gas containing oxygen. Therefore, a resist film for forming a pattern of a film composed of a material containing silicon must be suitably thick. On the other hand, since a film composed of a material containing silicon functions as an etching mask when a film composed of a material containing chromium is dry-etched with using a chlorine-based gas containing oxygen, and has etching resistance sufficiently to the dry etching using a chlorine-based gas containing oxygen, it is possible to thin the film composed of a material containing silicon for a hard mask, relatively. An etching time of the dry etching using a fluorine-based gas for the film composed of a material containing silicon is shortened when the film composed of a material containing silicon is thinned. As a result, the thickness of the resist film required for forming the pattern of the film composed of a material containing silicon can also be reduced.

For this reason, by using the film composed of a material containing silicon for the hard mask, it is possible to thin the resist film used for etching of the hard mask film, i.e., the resist film formed on and in contact with the hard mask film. By thinning the resist film, the height-to-width ratio (aspect ratio) of the resist film pattern is reduced, in development process for forming a resist film pattern, influence of impact of the developing solution or impact of pure water during rinsing is reduced, thus, a good assist pattern can be formed. As a result, it is possible to realize high resolution in a pattern transfer using a phase shift mask.

On the other hand, in the case that a phase shift film composed of a material containing molybdenum and silicon is dry-etched with using a fluorine-based gas, in some cases, the phase shift is adjusted to a phase shift of about 175 to 185 degrees with respect to exposure light with slightly etching the transparent substrate in contact with the phase shift film by the dry etching. In this case, the phase shift of the phase shift film composed of a material containing molybdenum and silicon itself is set to a phase shift of, for example, about 175 to 179 degrees, and the phase shift in the phase shift mask is adjusted to a phase shift of about 175 to 185 degrees by slightly carving the transparent substrate by the over-etching.

A general method for manufacturing a phase shift mask from a phase shift mask blank in which a phase shift film composed of a material containing molybdenum and silicon, a light-shielding film composed of a material containing chromium, and a hard mask film composed of a material containing silicon are formed in this order on a transparent substrate by patterning the phase shift film is as follows.

First, a resist film is formed on the hard mask film. Next, a resist film pattern is formed by drawing a pattern onto the resist film by light or an electron beam, and developing. Next, the hard mask film composed of a material containing silicon is dry-etched with using the resist film pattern as an etching mask, and a fluorine-based gas to form a hard mask film pattern, then, the resist film pattern is removed. Next, the light-shielding film composed of a material containing chromium is dry-etched with using the hard mask film pattern as an etching mask, and a chlorine-based gas containing oxygen to form a light-shielding film pattern. Next, the phase shift film composed of a material containing molybdenum and silicon is dry-etched with using the light-shielding film pattern as an etching mask, and a fluorine-based gas to form a phase shift film pattern, and the hard mask film pattern is simultaneously removed. Then, the light-shielding film pattern is removed by etching using a chlorine-based gas containing oxygen.

WO 2004/090635 A1 (Patent Document 1) discloses a phase shift mask blank including, on a translucent substrate, at least a phase shift film, a chromium film, a film for etching mask consisting of an inorganic material that is resistant to etching for the chromium film, and a resist film, and, as the materials for the film for etching mask, materials containing at least one of molybdenum, silicon, tantalum, and tungsten, in particular, simple Mo, MoSi, MoSiO, MoSiN, MoSiON, simple Si, SiO, SiN, SiON, simple Ta, TaB, W, WSi, and TaSi. Further, in the method for manufacturing a phase shift mask described in WO 2004/090635 A1 (Patent Document 1), a resist pattern is formed by exposing and developing a desired pattern onto a resist film, and the film for etching mask is dry-etched with using the resist pattern as a mask to form an etching mask pattern.

JP 2013-238691 A (Patent Document 2) discloses a phase shift mask blank in which a phase shift film, a light-shielding film, and a hard mask are laminated on a substrate transparent to exposure wavelength in sequence. The phase shift film and the light-shielding film are composed of a material that is not substantially etched by dry etching capable of etching the hard mask, the phase shift film and the hard mask are composed of a material that is not substantially etched by dry etching capable of etching the light-shielding film, and the light-shielding film is composed of a material that is not substantially etched by dry etching capable of etching the phase shift film. A metal compound film mainly composed of Cr oxide, Cr nitride, or Cr oxynitride, and a metal film or alloy film mainly composed of Cr are described for the light-shielding film, and a Ta film or a TaN film is described for the hard mask. Further, in the method for manufacturing a phase shift mask described in JP 2013-238691 A (Patent Document 2), a resist pattern is formed by applying a resist film onto the hard mask, and performing drawing, then performing developing process. A hard mask pattern is formed by patterning the hard mask by non-oxygen-containing chlorine-based dry etching (dry etching using chlorine gas as an etching gas) with using the resist pattern as a mask.

### Citation List

Patent Document 1: WO 2004/090635 A1
Patent Document 2: JP 2013-238691 A

### SUMMARY OF THE INVENTION

WO 2004/090635 (Patent Document 1) discloses a material containing silicon as a material for a film for etching mask. However, when a resist film is formed on the film composed of a material containing silicon, hydrophilic hydroxyl groups (OH groups) are easily formed on the surface of the film composed of a material containing silicon, and the hydroxyl groups deteriorate adhesion to the resist. In the case that the adhesion of the resist film to the film composed of a material containing silicon deteriorates, in development process for forming a resist film pattern, the resist film pattern easily collapses due to impact of a developing solution in development process or impact of pure water during rinsing and the resolution is significantly deteriorated.

Therefore, when a resist film is formed on a film composed of a material containing silicon, to improve the adhesion of the resist film to the film composed of the material containing silicon, the surface of the film composed of a material containing silicon is usually treated with HMDS (hexamethyldisilazane) to substitute the hydroxyl groups with hydrophobic groups before applying the resist onto the film composed of a material containing silicon, thereby improving the adhesion of the resist film to film composed of a material containing silicon.

However, while HMDS treatment improves the adhesion between the film composed of a material containing silicon and the resist film, the resist dissolves insufficiently in the development process. As a result, there is such a problem that, in a space pattern, the resist on the film composed of a material containing silicon is not completely removed, and resist residue remains on the film composed of a material containing silicon. This residue functions as an etching mask in etching the film composed of a material containing silicon. Thus, the portion to be etched for the film composed of a material containing silicon is not etched and remains, and eventually, the phase shift film at the position of the resist residue is not etched and remains, resulting in a defect. It is possible to correct the defect in the manufacturing process of a photomask such as phase shift mask, and it is also possible to evaluate effect of the correction to CD by wafer transfer simulation. However, defect correction affects productivity of the photomask, and in the case of including many defects, the productivity of photomask manufacturing is significantly deteriorated.

In addition, WO 2004/090635 A1 (Patent Document 1) discloses simple Ta, TaB, and TaSi as the material for the film for etching mask, and JP 2013-238691 A (Patent Document 2) discloses Ta and TaN as the material for hard mask. However, these materials easily react with oxygen, and an oxide layer is formed unevenly or locally on the surface of the film for etching mask or the hard mask by contacting with air. In that case, when the film for etching mask or the hard mask is dry-etched, the etching rate is uneven within the film surface, and the CD uniformity within the film surface is low and unstable.

Furthermore, the film for etching mask and the hard mask are necessary to be formed with a sufficient thickness that does not disappear during dry etching using a chlorine-based gas containing oxygen that is used for etching a film composed of a material containing chromium. These materials have a relatively high etching rate for dry etching using a chlorine-based gas containing oxygen, thus, the film for etching mask and the hard mask are necessary to be formed with a relatively large thickness. However, in the case that the film for etching mask or the hard mask is thick, it is necessary to form a thick resist film, and in the case that the resist film is thick, the height-to-width ratio (aspect ratio) of the resist film pattern having a narrow line width is high, resulting deterioration in resolution.

The present invention has been made to solve the above problems. An object of the present invention is to provide a photomask blank including a film, as a film that is formed on a film composed of a material containing chromium, that has good adhesion to a resist film without performing HMDS (hexamethyldisilazane) treatment, high uniformity of CD (Critical Dimension) in etching, and a low etching rate in dry etching using a chlorine-based gas containing oxygen, and to provide a method for manufacturing a photomask with using such a photomask blank.

The inventor has made earnestly studies to solve the above problems. As a result, with respect to a photomask blank including a transparent substrate, a film composed of a material containing chromium that is formed on the transparent substrate, and a film composed of a material containing tantalum that is formed on the film composed of a material containing chromium, furthermore, a photomask blank further including a film composed of a material containing silicon between the transparent substrate and the film composed of a material containing chromium, the inventor founds that the above problems can be solved by constituting the film composed of a material containing tantalum so as to contain nitrogen and to have a prescribed structure, composition and thickness.

Further, the inventor founds that the photomask blank is suitable in the case that the film composed of a material containing chromium is a light-shielding film and the film composed of a material containing tantalum is a hard mask film, furthermore, the film composed of a material containing silicon is a phase shift film.

Moreover, the inventor founds that when a photomask is manufactured from such a photomask blank, the film composed of a material containing tantalum can be etched by dry etching using a fluorine-based gas, and a photomask in which finer assist patterns are favorably formed in a circuit pattern by forming a resist film that is on and in contact with the film composed of a material containing tantalum, and etching the film composed of a material containing tantalum, the film composed of a material containing chromium, and the film composed of a material containing silicon, respectively, by dry etching using a fluorine-based gas, dry etching using a chlorine-based gas containing oxygen, and dry etching using a fluorine-based gas.

In one aspect, the invention provides a photomask blank including a photomask blank including a transparent substrate, a film composed of a material containing chromium that is formed on the transparent substrate, and a film composed of a material containing tantalum that is formed on the film composed of a material containing chromium, wherein
the film composed of a material containing tantalum is constituted of a single layer or multiple layers,
the film composed of a material containing tantalum has a thickness of not less than 0.5 nm and not more than 15 nm,
the material containing tantalum contains tantalum, and oxygen or oxygen and nitrogen, and is free of silicon,
the single layer and at least the layer remotest from the transparent substrate among the layers constituting the multiple layers are composed of a material containing tantalum that has a tantalum content of not less than 40 at% and not more than 80 at%, an oxygen content of not less than 5 at% and not more than 50 at%, and a nitrogen content of not more than 50 at%, and
the layer remotest from the transparent substrate has a thickness of not less than 0.5 nm.

Preferably, in the photomask blank, when the film composed of a material containing chromium and the film composed of a material containing tantalum are subjected to dry etching using a chlorine-based gas containing oxygen, a ratio of an etching rate of the film composed of a material containing chromium to an etching rate of the film composed of a material containing tantalum is not less than 50.

Preferably, the film composed of a material containing chromium has a thickness of not less than 30 nm and not more than 80 nm.

Preferably, the photomask blank further includes a film composed of a material containing silicon between the transparent substrate and the film composed of a material containing chromium.

Preferably, the film composed of a material containing silicon is a phase shift film,
the film composed of a material containing chromium is a light-shielding film, and
the film composed of a material containing tantalum is a hard mask film.

Preferably, the phase shift film has a phase shift of not less than 175 degrees and not more than 185 degrees, and a transmittance of not less than 6% and not more than 30%, with respect to exposure light, and a thickness of not less than 60 nm and not more than 85 nm.

Preferably, the light-shielding film and the phase shift film has a total optical density of not less than 3 with respect to the exposure light.

Preferably, the photomask blank further includes a resist film that is in contact with the film composed of a material containing tantalum at the side remote from the transparent substrate, and has a thickness of not less than 40 nm and not more than 120 nm.

In another aspect, the invention provides a method for manufacturing a photomask including a circuit pattern of the film composed of a material containing chromium from the photomask blank of any one of claims 1 to 3, wherein the method includes the steps of:
(A) forming a first resist film that is in contact with the film composed of a material containing tantalum at the side remote from the transparent substrate,
(B) patterning the first resist film to form a first resist film pattern,
(C) patterning the film composed of a material containing tantalum to form a pattern of the film composed of a material containing tantalum by dry etching using a fluorine-based gas, and the first resist film pattern as an etching mask,
(D) removing the first resist film pattern,
(E) patterning the film composed of a material containing chromium to form a pattern of the film composed of a material containing chromium by dry etching using a chlorine-based gas containing oxygen, and the pattern of the film composed of a material containing tantalum as an etching mask, and
(F1) removing the pattern of the film composed of a material containing tantalum by dry etching using a fluorine-based gas.

In the other aspect, the invention provides a method for manufacturing a photomask including a circuit pattern of the film composed of a material containing silicon from the photomask blank of claim 4, wherein the method includes the steps of:
(A) forming a first resist film that is in contact with the film composed of a material containing tantalum at the side remote from the transparent substrate,
(B) patterning the first resist film to form a first resist film pattern,
(C) patterning the film composed of a material containing tantalum to form a pattern of the film composed of a material containing tantalum by dry etching using a fluorine-based gas, and the first resist film pattern as an etching mask,
(D) removing the first resist film pattern,
(E) patterning the film composed of a material containing chromium to form a pattern of the film composed of a material containing chromium by dry etching using a chlorine-based gas containing oxygen, and the pattern of the film composed of a material containing tantalum as an etching mask,
(F2) patterning the film composed of a material containing silicon to form a pattern of the film composed of a material containing silicon that includes the circuit pattern by dry etching using a fluorine-based gas, and the film composed of a material containing chromium as an etching mask, and simultaneously removing the film composed of a material containing tantalum,
(G) forming a second resist film that in contact with the pattern of the film composed of a material containing chromium and the exposed transparent substrate at the side remote from the transparent substrate of the film composed of a material containing chromium,
(H) patterning the second resist film to form a second resist film pattern only at the outer periphery portion of the transparent substrate that is a region not including the circuit pattern,
(I) removing the pattern of the film composed of a material containing chromium at the portion other than the outer periphery by dry etching using a chlorine-based gas containing oxygen, and the second resist film pattern as an etching mask, so that the pattern of the film composed of the material containing chromium remains at the outer periphery, and
(J) removing the second resist film pattern.

Preferably, in the method, the film composed of a material containing silicon is a phase shift film,
the film composed of a material containing chromium is a light-shielding film, and
the film composed of a material containing tantalum is a hard mask film.

### ADVANTAGEOUS EFFECTS

The film composed of a material containing tantalum in the photomask blank of the invention has good adhesion to a resist film without performing HMDS (hexamethyldisilazane) treatment, thus, it can avoid the problem of resist residues that occurs when the HMDS treatment is performed.

In addition, the film composed of a material containing tantalum in the photomask blank of the invention is hard to be oxidized in air, thus, an oxide layer is hard to be formed at the surface portion of the film. Therefore, it can avoid the problem of deterioration and destabilization of the CD uniformity within the film surface due to uneven etching rate within the film surface that is derived from an oxide layer unevenly or locally formed on the surface of the film.

Further, the film composed of a material containing tantalum in the photomask blank of the invention has a low etching rate of dry etching using a chlorine-based gas containing oxygen, thus, a thin resist film that is formed on and in contact with the film composed of a material containing tantalum can be used by forming a thinner film composed of a material containing tantalum.

Furthermore, the photomask blank of the invention has high resolution, and by manufacturing a photomask with using the photomask blank of the invention, a thin resist film can be formed on and in contact with a film composed of a material containing tantalum with good adhesion, and a low height-to-width ratio (aspect ratio) is accomplished even when a resist film pattern has a narrow line width. Thus, it can avoid the problem of collapse of the resist film pattern due to impact of a developing solution in development process or impact of pure water during rinsing in development process for forming a resist film pattern.

Therefore, from the photomask blank of the invention, an assist pattern with a narrow line width can be successfully formed as an assist pattern for a line pattern formed in a circuit pattern. Particularly, in the case of a photomask blank having a film composed of a material containing silicon between a transparent substrate and a film composed of a material containing chromium, especially in the case of a phase shift mask blank in which the film formed of a material containing silicon is a phase shift film, for example, the assist pattern can be successfully formed even when the assist pattern has a line width of about 40 nm, further about 36 nm, and a photomask having a circuit pattern with high CD uniformity and few defects can be obtained.

### BRIEF DESCRIPTION OF THE DRAWINGS

FIG. 1 is a cross-sectional view illustrating an example of first embodiment of a photomask blank of the invention.
FIG. 2 is a cross-sectional view illustrating an example of second embodiment of a photomask blank of the invention.
FIG. 3 is a cross-sectional view illustrating an example of third embodiment of a photomask blank of the invention.
FIG. 4 is a cross-sectional view illustrating an example of fourth embodiment of a photomask blank of the invention.
FIG. 5 is a cross-sectional view illustrating an example of first embodiment of a photomask of the invention.
FIG. 6 is a cross-sectional view illustrating an example of second embodiment of a photomask of the invention.
FIGS. 7A to 7F are cross-sectional views for explaining steps of manufacturing a reflective photomask of first embodiment from a reflective photomask blank of first embodiment or third embodiment.
FIGS. 8A to 8J are cross-sectional views for explaining steps of manufacturing a reflective photomask of second embodiment from a reflective photomask blank of second embodiment or fourth embodiment.

### FURTHER EXPLANATIONS; OPTIONS AND PREFERENCES

### [Photomask Blank]

A photomask blank of the invention includes a transparent substrate, a film composed of a material containing chromium, and a film composed of a material containing tantalum. The film composed of a material containing chromium is formed on the substrate directly or via another film. Another film may be formed between the film composed of a material containing chromium and the film composed of a material containing tantalum, however, the film composed of a material containing tantalum is preferably formed in contact with the film composed of a material containing chromium.

A photomask blank and a photomask of the invention preferably target exposure light that is light having a wavelength of not more than 250 nm, particularly light having a wavelength of not more than 200 nm, such as ArF excimer laser (wavelength: 193 nm) and F₂ laser (wavelength: 157 nm), however not particularly limited thereto.

The invention is described below with reference to the drawings. Identical components may be given the same reference symbols and their duplicate description may be omitted. In addition, the drawings may be enlarged or reduced for convenience, and the dimensional ratio of each component may not be the same as the actual ratio.

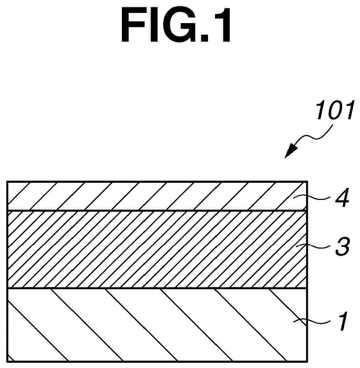

FIG. 1 is a cross-sectional view illustrating an example of first embodiment of a photomask blank of the invention. This photomask blank 101 includes, on a transparent substrate 1, a film composed of a material containing chromium 3 that is formed in contact with the transparent substrate 1, and a film composed of a material containing tantalum 4 that is formed in contact with the film composed of a material containing chromium 3. In first embodiment of a photomask blank, on a transparent substrate, a film composed of a material containing chromium, and a film composed of a material containing tantalum are formed in the order from the side of the substrate.

Preferably, the photomask blank of the invention further includes a film composed of a material containing silicon between the transparent substrate and the film composed of a material containing chromium. The photomask blank of the invention may include a transparent substrate, a film composed of a material containing silicon, a film composed of a material containing chromium, and a film composed of a material containing tantalum. The film composed of a material containing silicon is formed on the substrate directly or via another film. Further, another film may be formed between the film composed of a material containing silicon and the film composed of a material containing chromium, however, the film composed of a material containing silicon is preferably formed in contact with the film composed of a material containing chromium.

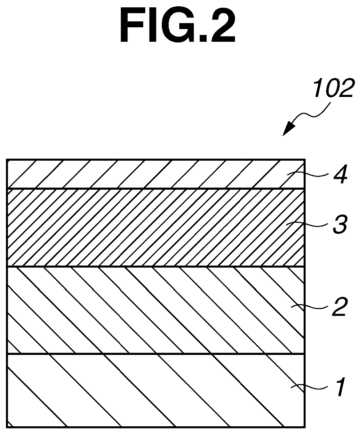

FIG. 2 is a cross-sectional view illustrating an example of second embodiment of a photomask blank of the invention. This photomask blank 102 includes, on a transparent substrate 1, a film composed of a material containing silicon 2 that is formed in contact with the transparent substrate 1, a film composed of a material containing chromium 3 that is formed in contact with the film composed of a material containing silicon 2, and a film composed of a material containing tantalum 4 that is formed in contact with the film composed of a material containing chromium 3. In second embodiment of a photomask blank, on a transparent substrate, a film composed of a material containing silicon, a film composed of a material containing chromium, and a film composed of a material containing tantalum are formed in the order from the side of the substrate.

The photomask blank of the invention may further include a resist film that is in contact with the film composed of a material containing tantalum at the side remote from the transparent substrate.

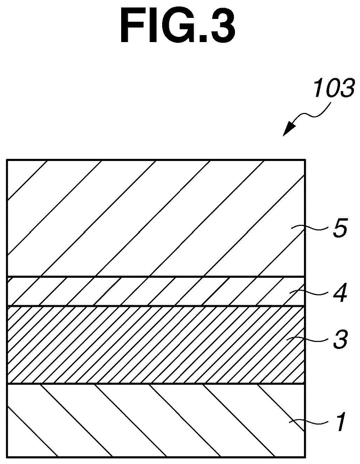

FIG. 3 is a cross-sectional view illustrating an example of third embodiment of a photomask blank of the invention. This photomask blank 103 includes, on a transparent substrate 1, a film composed of a material containing chromium 3 that is formed in contact with the transparent substrate 1, a film composed of a material containing tantalum 4 that is formed in contact with the film composed of a material containing chromium 3, and a resist film 5 that is formed in contact with the film composed of a material containing tantalum 4. In third embodiment of a photomask blank, on a transparent substrate, a film composed of a material containing chromium, a film composed of a material containing tantalum, and a resist film are formed in the order from the side of the substrate.

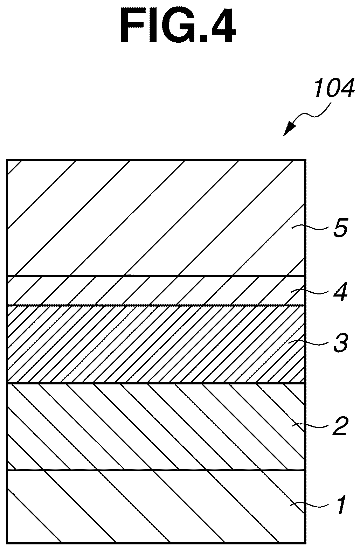

FIG. 4 is a cross-sectional view illustrating an example of fourth embodiment of a photomask blank of the invention. This photomask blank 104 includes, on a transparent substrate 1, a film composed of a material containing silicon 2 that is formed in contact with the transparent substrate 1, a film composed of a material containing chromium 3 that is formed in contact with the film composed of a material containing silicon 2, a film composed of a material containing tantalum 4 that is formed in contact with the film composed of a material containing chromium 3, and a resist film 5 that is formed in contact with the film composed of a material containing tantalum 4. In fourth embodiment of a photomask blank, on a transparent substrate, a film composed of a material containing silicon, a film composed of a material containing chromium, a film composed of a material containing tantalum, and a resist film are formed in the order from the side of the substrate.

### [Transparent Substrate]

Material or sizes of the transparent substrate are not particularly limited, and a preferable substrate is a substrate transparent to exposure light that is used for a transmissive photomask blank and a transmissive photomask, in particular, a quartz substrate such as a synthesis quartz substrate. A suitable transparent substrate is a substrate called a 6025 substrate having sizes of 6 inches square and a thickness of 0.25 inches, which is defined in the SEMI standard. The 6025 substrate is generally represented a substrate having sizes of 152 mm square and 6.35 mm thick in the SI unit system.

### [Film Composed of a Material Containing Silicon]

The film composed of a material containing silicon (Si) may be constructed with a single layer or multiple layers (for example, a film constituted of two to five layers). The single layer and each layer constituting the multiple layers may have single composition or gradient composition.

The film composed of a material containing silicon is preferably composed of a material that is resistant to dry etching using a chlorine-based gas containing oxygen, and can be removed by dry etching using a fluorine-based gas.

In the invention, as a typical dry etching using a fluorine-based gas, dry etching using a fluorine-containing gas such as CF₄ gas and SF₆ gas as an etching gas is exemplified. In the invention, as a typical dry etching using a chlorine-based gas containing oxygen, dry etching using a mixed gas of chlorine gas (Cl₂ gas) and oxygen gas (O₂ gas) is exemplified. As the mixed gas of chlorine gas and oxygen gas, a gas in which chlorine gas is mixed with 10 to 25 vol% of oxygen gas is preferable.

The material containing silicon is preferably a material containing silicon and being free of transition metals, or a material containing a transition metal (Me) other than chromium, and silicon, and being free of chromium (Cr). As the material containing silicon and being free of transition metals, simple silicon (Si), or a silicon compound containing silicon, and at least one selected from the group consisting of oxygen (O), nitrogen (N) and carbon (C) is exemplified. As such a silicon compound, examples of the materials include a material consisting of silicon and oxygen (SiO), a material consisting of silicon and nitrogen (SiN), a material consisting of silicon, oxygen and nitrogen (SiON), a material consisting of silicon and carbon (SiC), a material consisting of silicon, oxygen and carbon (SiOC), a material consisting of silicon, nitrogen and carbon (SiNC), and a material consisting of silicon, oxygen, nitrogen and carbon (SiONC).

On the other hand, as the material containing a transition metal (Me) other than chromium, and silicon, and being free of chromium, a transition metal (Me) silicon compound containing a transition metal (Me) and silicon (Si), or a transition metal (Me) silicon compound containing a transition metal (Me), silicon (Si), and at least one selected from the group consisting of oxygen (O), nitrogen (N) and carbon (C) is exemplified. As such a transition metal (Me) silicon compound, examples of the materials include a material consisting of a transition metal and silicon (MeSi), a material consisting of a transition metal, silicon and oxygen (MeSiO), a material consisting of a transition metal, silicon and nitrogen (MeSiN), a material consisting of a transition metal, silicon, oxygen and nitrogen (MeSiON), a material consisting of a transition metal, silicon and carbon (MeSiC), a material consisting of a transition metal, silicon, oxygen and carbon (MeSiOC), a material consisting of a transition metal, silicon, nitrogen and carbon (MeSiNC), and a material consisting of a transition metal, silicon, oxygen, nitrogen and carbon (MeSiONC).

As the transition metal (Me) other than chromium, at least one selected from the group consisting of molybdenum (Mo), tungsten (W), tantalum (Ta), titanium (Ti), zirconium (Zr) and hafnium (Hf) is suitable, and molybdenum is particularly suitable in the viewpoint of processability in dry etching. In addition, the film composed of a material containing silicon may contains hydrogen (H) or others.

The film composed of a material containing silicon has a thickness of preferably not less than 50 nm, more preferably not less than 60 nm, and preferably not more than 90 nm, more preferably not more than 85 nm.

The film composed of a material containing silicon is suitable for an optical film, particularly a phase shift film that is used in a photomask blank such as a transmissive photomask blank, and a photomask such as a transmissive photomask. In the case that the film composed of a material containing silicon is a phase shift film, the photomask blank is a phase shift mask blank, and a phase shift mask including a pattern of the phase shift film is manufactured from the phase shift mask blank. In the case that the phase shift film is a halftone phase shift film, the phase shift mask blank and the phase shift mask are a halftone phase shift mask blank and a halftone phase shift mask, respectively.

In the case that the film composed of a material containing silicon is a phase shift film, the phase shift film preferably has a phase shift of not less than 175 degrees and not more than 185 degrees, with respect to exposure light. In the case that the film composed of a material containing silicon is a phase shift film, the phase shift film has a transmittance of preferably not less than 4%, more preferably not less than 6%, and preferably not more than 50%, more preferably not more than 30%, with respect to the exposure light, however, the transmittance of not less than 6% and not more than 30% that provides high effect in resolution and focus depth of a transfer pattern by the phase shift effect depending to exposure conditions is more preferable. In the case that the film composed of a material containing silicon is a phase shift film, the phase shift film preferably has a thickness of preferably not less than 50 nm, more preferably not less than 60 nm, and preferably not more than 90 nm, more preferably not more than 85 nm to set the phase shift and the transmittance within prescribed ranges.

### [Film Composed of a Material Containing Chromium]

The film composed of a material containing chromium (Cr) may be constructed with a single layer or multiple layers (for example, a film constituted of two to five layers). The single layer and each layer constituting the multiple layers may have single composition or gradient composition.

The film composed of a material containing chromium is preferably composed of a material that is resistant to dry etching using a fluorine-based gas, and can be removed by dry etching using a chlorine-based gas containing oxygen.

The material containing chromium is preferably a material being free of silicon (Si). The material containing chromium is preferably a material being free of tantalum (Ta). As the material containing chromium, simple chromium (Cr), or a chromium compound containing silicon, and at least one selected from the group consisting of oxygen (O), nitrogen (N) and carbon (C) is exemplified. As such a chromium compound, examples of the materials include a material consisting of chromium and oxygen (CrO), a material consisting of chromium and nitrogen (CrN), a material consisting of chromium, oxygen and nitrogen (CrON), a material consisting of chromium and carbon (CrC), a material consisting of chromium, oxygen and carbon (CrOC), a material consisting of chromium, nitrogen and carbon (CrNC), and a material consisting of chromium, oxygen, nitrogen and carbon (CrONC). Particularly, the material consisting of chromium, oxygen and nitrogen (CrON) and the material consisting of chromium, oxygen, nitrogen and carbon (CrONC) are suitable as the material containing chromium.

The film composed of a material containing chromium has a thickness of preferably not more than 86 nm, more preferably not more than 80 nm, even more preferably not more than 70 nm, and preferably not less than 30 nm, more preferably not less than 32 nm.

When the film composed of a material containing chromium is too thick, the film has a long clear time in dry etching using a chlorine-based gas containing oxygen. As described later, when the film composed of a material containing chromium is etched by dry etching using a chlorine-based gas containing oxygen, and a pattern of the film composed of a material containing tantalum as an etching mask, the film composed of a material containing tantalum is also etched little by little by the dry etching using chlorine-based gas containing oxygen. In the case that the film composed of the material containing tantalum disappears, pinhole defects occur in the film composed of a material containing chromium.

Therefore, the film composed of the material containing tantalum is also required to have an at least certain thickness depending on the thickness of the film composed of a material containing chromium. To reduce a thickness of the resist film that is formed in contact with the film composed of a material containing tantalum, it is preferable that the film composed of a material containing tantalum is thin, and it is preferable that the film composed of a material containing chromium is also thin. The film composed of a material containing chromium has a thickness of preferably not more than 80 nm, more preferably not more than 70 nm from this point of view.

The film composed of a material containing chromium is suitable for an optical film, particularly a light-shielding film that is used in a photomask blank such as a transmissive photomask blank, and a photomask such as a transmissive photomask.

In the case that the film composed of a material containing silicon is a phase shift film, and the film composed of a material containing chromium is a light-shielding film, particularly in the case that the light-shielding film is remained as a light-shielding portion (a light-shielding film pattern) on the outer periphery portion of the transparent substrate, which is an area in which a circuit pattern of the phase shift film is not formed, the phase shift film and the light-shielding film is formed with setting a predetermined total optical density (OD) (for example, more than 2, particularly not less than 2.5), however, the phase shift film and the light-shielding film preferably has a total optical density (OD) of not less than 3.

For example, when the phase shift film has a transmittance of not less than 6% and not more than 30% (optical density of not less than 0.53 and not more than 1.22) with respect to exposure light, to obtain the total optical density of the phase shift film and the light-shielding film of not less than 3, the optical density of the light-shielding film must be not less than 1.78 with respect to the exposure light. Therefore, the light-shielding film has a thickness of preferably not less than 30 nm, more preferably not less than 32 nm.

### [Film Composed of a Material Containing Tantalum]

The film composed of a material containing tantalum (Ta) may be constructed with a single layer or multiple layers (for example, a film constituted of two to five layers). The single layer and each layer constituting the multiple layers may have single composition or gradient composition.

The film composed of a material containing tantalum is preferably composed of a material that is resistant to dry etching using a chlorine-based gas containing oxygen, and can be removed by dry etching using a fluorine-based gas. When the film composed of a material containing tantalum is composed of a material that can be removed by dry etching using a fluorine-based gas, a pattern of the film composed of a material containing tantalum can be simultaneously removed in etching the film composed of a material containing silicon to form a pattern of the film composed of a material containing silicon by dry etching using a fluorine-based gas.

Generally, the film composed of a material containing tantalum will contact with a resist film, and will contact with a cleaning solution when the photomask blank is cleaned before forming the resist film in manufacturing a photomask. Therefore, it is required that the film composed of a material containing tantalum has high adhesion to the resist film and high chemical resistance to the cleaning solution. Further, the film composed of a material containing tantalum is usually a film located remotest from the transparent substrate among the films in the photomask blank. Therefore, it is required that the film has a low reflectance to light used for inspection such as defect inspection of the photomask blank.

In the invention, a material containing tantalum for the film composed of a material containing tantalum is a material containing tantalum, and oxygen (O) or oxygen (O) and nitrogen (N) (a material containing tantalum and oxygen, or containing tantalum, oxygen and nitrogen), and a material being free of silicon (Si). Further, in the invention, the material containing tantalum for the film composed of a material containing tantalum is preferably a material being free of chromium (Cr). As the material containing tantalum, and oxygen or oxygen and nitrogen, and being free of silicon, tantalum oxide or tantalum oxynitride, in particular, a material consisting of tantalum and oxygen (TaO), and a material consisting of tantalum, oxygen and nitrogen (TaON) are exemplified. In addition, in the invention, the material containing tantalum for the film composed of a material containing tantalum may further contain boron (B).

In the case that the film composed of a material containing tantalum is constructed with multiple layers, each layer constituting the multiple layers is composed of a material containing tantalum. In the case that the film composed of a material containing tantalum is constructed with multiple layers, at least one layer constituting the multiple layers is formed with a material containing tantalum, and oxygen (O) or oxygen (O) and nitrogen (N), and being free of silicon (Si). In this case, the material containing tantalum forming the other layer(s) constituting the multiple layers may be simple tantalum (Ta), a material consisting of tantalum and nitrogen (TaN) or others. In the case that the film composed of a material containing tantalum is constructed with multiple layers, preferably, each material forming the layer constituting the multiple layers is a material containing tantalum, and oxygen (O) or oxygen (O) and nitrogen (N), and a material being free of silicon (Si).

Materials containing tantalum and being free of silicon, particularly, a material consisting of tantalum and oxygen (TaO), and a material consisting of tantalum, oxygen and nitrogen (TaON) are less likely to form hydroxyl groups (OH groups) which are hydrophilic groups on the surface, compared with materials containing silicon. Therefore, the film composed of a material containing tantalum and being free of silicon has good adhesion to a resist film even when HMDS treatment is not performed, and can avoid the problem of resist residue caused in the case that the HMDS treatment is performed to the film composed of a material containing silicon.

Materials containing tantalum and oxygen, particularly, a material consisting of tantalum and oxygen (TaO), and a material consisting of tantalum, oxygen and nitrogen (TaON) has higher chemical stability in the air, is less likely to react with oxygen in the air, and is less likely to form an oxide layer on the surface of the film, compared with materials containing tantalum and being free of oxygen such as simple tantalum (Ta) and a material consisting of tantalum and nitrogen (TaN). Therefore, in etching, the film composed of a material containing tantalum and oxygen has a uniform etching rate within the film surface, and fine CD uniformity is maintained within the film surface. Accordingly, the film composed of a material containing tantalum and oxygen can avoid the problem of reduction and destabilization of the CD uniformity within the film surface due to uneven etching rate within the film surface that is caused by forming an oxide layer unevenly or locally on the surface portion of the film.

The material containing tantalum for the film composed of a material containing tantalum, particularly, in the case the film composed of a material containing tantalum is a single layer, the material containing tantalum forming the single layer, or in the case that the film composed of a material containing tantalum is multiple layers, the material containing tantalum forming at least the layer remotest from the transparent substrate among the layers constituting the multiple layers, preferably the material containing tantalum forming two or more layers constituting the multiple layers, more preferably the material containing tantalum forming each layer constituting the multiple layers preferably satisfies the following content ranges of tantalum, oxygen and nitrogen.

### <Content Ranges of Tantalum, Oxygen and Nitrogen>

Tantalum content: preferably not less than 40 at%, more preferably not less than 42 at%, and preferably not more than 80 at%, more preferably not more than 70 at%
Oxygen content: preferably not less than 5 at%, more preferably not less than 10 at%, and preferably not more than 50 at%, more preferably not more than 45 at%
Nitrogen content (in the case of containing nitrogen): preferably not more than 50 at%, more preferably not more than 40 at%.

When the film composed of a material containing chromium is etched by dry etching using a chlorine-based gas containing oxygen, and a pattern of the film composed of a material containing tantalum as an etching mask, the film composed of a material containing tantalum is also etched little by little by the dry etching using chlorine-based gas containing oxygen. In the case that the film composed of the material containing tantalum disappears, pinhole defects occur in the film composed of a material containing chromium.

Thus, in the dry etching using a chlorine-based gas containing oxygen, it is preferable that an etching rate of the film composed of a material containing tantalum is sufficiently low to an etching rate of the film composed of a material containing chromium. To an etching rate of the film composed of a material containing tantalum in the dry etching using a chlorine-based gas containing oxygen under one condition, a ratio of an etching rate of the film composed of a material containing chromium in dry etching using a chlorine-based gas containing oxygen under the condition (same condition) is preferably not less than 50, more preferably not less than 100. The ratio is normally not more than 3000, however, not particularly limited thereto.

Materials containing tantalum and oxygen, particularly, a material consisting of tantalum and oxygen (TaO), and a material consisting of tantalum, oxygen and nitrogen (TaON) has higher resistance to dry etching using a chlorine-based gas containing oxygen and a lower etching rate of the dry etching using a chlorine-based gas containing oxygen, compared with materials containing tantalum and being free of oxygen such as simple tantalum (Ta) and a material consisting of tantalum and nitrogen (TaN). Therefore, the film composed of a material containing tantalum and oxygen can be formed thinly.

The film composed of a material containing tantalum has a thickness (a thickness of a single layer when the film is constituted of a single layer, or a thickness of the sum of the whole layers when the film is constituted of multiple layers) of preferably not more than 15 nm, more preferably not more than 12 nm, and preferably not less than 0.5 nm, more preferably not less than 1 nm, even more preferably not less than 4 nm, further preferably not less than 6 nm.

Further, in the case that the film composed of a material containing tantalum is constituted of multiple layers, the layer remotest from the transparent substrate has a thickness of preferably not less than 0.5 nm, more preferably not less than 1 nm, even more preferably not less than 2 nm, further preferably not less than 4 nm. In the layer(s) constituting the multiple layers, the total thickness of the layer(s) that satisfy the above content ranges of tantalum, oxygen and nitrogen is preferably not less than 0.5 nm, more preferably not less than 1 nm, even more preferably not less than 2 nm, further preferably not less than 4 nm, and preferably not more than 15 nm, more preferably not more than 12 nm.

When the film composed of a material containing tantalum is too thick, the film has a long clear time in dry etching using a fluorine-based gas. As described later, when the film composed of a material containing tantalum is etched by dry etching using a fluorine-based gas, and a resist film pattern as an etching mask, the resist film is also etched little by little by the dry etching using fluorine-based gas. In the case that the resist film disappears, pinhole defects occur in the film composed of a material containing tantalum.

Therefore, the resist film is also required to have a certain thickness or more depending on the thickness of the film composed of a material containing tantalum. To reduce a thickness of the resist film that is formed in contact with the film composed of a material containing tantalum, it is preferable that the film composed of a material containing tantalum is thin. A thick film composed of a material containing tantalum cannot provide high resolution since the resist film cannot be thinned. The film composed of a material containing tantalum has a thickness of preferably not more than 15 nm, more preferably not more than 12 nm from this point of view.

On the other hand, when the film composed of a material containing tantalum is too thin, sufficient inspection sensitivity may not be obtained for light used in inspections such as defect inspection of a photomask blank, and for example, defects having a size of not more than 100 nm may not be detected. The film composed of a material containing tantalum has a thickness of preferably not less than 4 nm, more preferably not less than 6 nm from this point of view.

The film composed of a material containing tantalum is suitable for a processing aid film, particularly a hard mask film that is used in a photomask blank such as a transmissive photomask blank, and a photomask such as a transmissive photomask.

### [Resist Film]

The resist film may be an electron beam resist that is drawn with an electron beam or a photoresist that is drawn with light, and particularly, a chemically amplified resist is preferable. The chemically amplified resist may be a positive type or a negative type. Examples of the resists include a resist containing a base resin such as a hydroxystyrene-based resin or a (meth)acrylic acid-based resin, and an acid generator, and optionally containing a cross-linking agent, a quencher, a surfactant, or other components. The resist film has a thickness of preferably not more than 120 nm, more preferably not more than 100 nm, even more preferably not more than 90 nm, further preferably not more than 70 nm to prevent the resist film pattern from collapsing during development process and rinsing process after development in the case of forming fine patterns. The thickness of the resist film is not limited as long as the resist film can be formed with uniform thickness, however, the thickness normally has a lower limit of not less than 40 nm.

### [Film Forming Method]

The film composed of a material containing silicon (each layer constituting the film), the film composed of a material containing chromium (each layer constituting the film), and the film composed of a material containing tantalum (each layer constituting the film) are preferably formed by a sputtering method that has good controllability and can be easy to form a film having predetermined characteristics, however, not particularly limited thereto. As the sputtering method, DC sputtering, or RF sputtering can be applied, however, not particularly limited thereto.

When the film composed of a material containing silicon is formed, particularly, when the film is formed with a material containing silicon and being free of transition metals, a silicon target may be used as a sputtering target. On the other hand, when the film composed of a material containing silicon is formed with a material containing a transition metal (Me) other than chromium, and silicon, particularly, a material containing a transition metal (Me) other than chromium, and silicon, and being free of chromium, a target appropriately selected from the group consisting of a target of a transition metal (Me) other than chromium, a silicon target, and a target containing a transition metal (Me) other than chromium, and silicon, and being free of chromium may be used as a sputtering target, and if needed, co-sputtering may be applied with using two or more kinds of targets. As the targets containing a transition metal (Me) other than chromium, and silicon and being free of chromium, two or more targets having different compositions (a part or all of the constituent elements are different, or the constituent elements are the same, and the contents thereof are different) may be used.

When the film composed of a material containing chromium is formed, particularly, when the film is formed with a material containing chromium and being free of either or both of silicon and tantalum, a chromium target may be used as a sputtering target.

When the film composed of a material containing tantalum is formed, particularly, when the film is formed with a material containing tantalum and being free of silicon or silicon and chromium, a tantalum target may be used as a sputtering target. Further, when the film composed of a material containing tantalum is formed with a material containing tantalum and boron, a target consisting of tantalum and boron (TaB target) may be used as a sputtering target.

A power to be supplied to the sputtering target may be appropriately set depending on the size of the sputtering target, cooling efficiency, controllability of film formation. The power is normally 0.1 to 10 W/cm² as a power per area of the sputtering surface of the sputtering target. As a sputtering gas, a rare gas such as helium gas (He gas), neon gas (Ne gas) and argon gas (Ar gas) may be used. When the film that contains only the element constituting the target is formed, only the rare gas may be used as the sputtering gas.

When the film is formed with a material containing at least one light element selected from the group consisting of oxygen (O), nitrogen (N), carbon (C) and hydrogen (H), the sputtering is preferably reactive sputtering. In the reactive sputtering, a rare gas such as helium gas (He gas), neon gas (Ne gas) and argon gas (Ar gas), and a reactive gas are used as sputtering gases.

As the reactive gas, for example, oxygen gas (O₂ gas) can be used in the case of forming by a material containing oxygen (O), nitrogen gas (N₂ gas) can be used in the case of forming by a material containing nitrogen (N), a nitrogen oxide gas such as nitrogen monoxide gas (NO gas), nitrogen dioxide gas (NO₂ gas) and nitrous oxide gas (N₂O gas) can be used in the case of forming by a material containing oxygen (O) and nitrogen (N), a carbon oxide gas such as carbon monoxide gas (CO gas) and carbon dioxide gas (CO₂) can be used in the case of forming by a material containing carbon (C) and oxygen (O), and a hydrogen carbon gas such as methane gas (CH₄ gas) can be used in the case of forming by a material containing carbon (C) and hydrogen (H).

Particularly, when the film is formed with a material contains oxygen (O) and nitrogen (N), a gas appropriately selected from the group consisting of oxygen gas (O gas), nitrogen gas (N gas), and nitrogen oxide gases such as nitrogen monoxide gas (NO gas), nitrogen dioxide gas (NO₂ gas), and nitrous oxide gas (N₂O gas) may be used, and two or more types of gases may also be used, if necessary.

A pressure in forming each film may be appropriately set in consideration of film stress, chemical resistance, cleaning resistance. Particularly, chemical resistance is improved by setting the pressure at preferably not less than 0.01 Pa, more preferably not less than 0.03 Pa, and preferably not more than 1 Pa, more preferably not more than 0.3 Pa. Further, a flow rate of each gas may be appropriately set so as to obtain a desired composition, and may be set normally 0.1 to 100 sccm.

In manufacturing process of the photomask blank, the transparent substrate or the transparent substrate and the film formed on the transparent substrate may be heat-treated before forming the resist film. As a heat treatment method, an infrared heating, a resistance heating or others can be applied, and conditions of the treatment are not particularly limited. The heat treatment may be performed, for example, under atmosphere of a gas containing oxygen such as in the air. The gas containing oxygen has a concentration of, for example, 1 to 100 vol% in the case of oxygen gas (O₂ gas), however not particularly limited thereto. The heat treatment is performed at a temperature of preferably not less than 200 °C, more preferably not less than 400 °C.

In manufacturing process of the photomask blank, before forming the resist film, the film formed on the transparent substrate, particularly the film composed of a material containing chromium may be subjected to ozone treatment, or plasma treatment, and the condition for the treatment are not particularly limited. Each treatment may be carried out to increase oxygen concentration in the surface portion of the film. In this case, the conditions of the treatment may be appropriately adjusted so as to obtain a predetermined oxygen concentration. In addition, when the film is formed by sputtering, the oxygen concentration in the surface portion of the film can be increased also by adjusting a ratio of the rare gas and the gas containing oxygen (oxidizing gas) such as oxygen gas (O₂ gas), carbon monoxide gas (CO gas), and carbon dioxide gas (CO₂ gas) in the sputtering gas.

Further, in manufacturing process of the photomask blank, before forming the resist film, a cleaning treatment may be performed to remove particles which present on the surface of the transparent substrate or the film formed on the transparent substrate. The cleaning can be performed with using either or both of ultrapure water and a functional water, which is ultrapure water containing ozone gas, hydrogen gas, or others. Further, the cleaning may be performed by ultrapure water containing a surfactant, followed by cleaning with either or both of ultrapure water and the functional water. The cleaning may be performed while irradiating with ultrasonic wave, if necessary, and may also be combined with UV light irradiation.

A method of forming the resist film (applying the resist) is not particularly limited, and a known method such as spin coating may be applied.

### [Photomask]

From the photomask blank of the invention, a photomask including a circuit pattern (photomask pattern) of the film composed of a material containing chromium can be manufactured. In the case of including the circuit pattern (photomask pattern) of the film composed of a material containing chromium, the film composed of a material containing chromium is preferably a light-shielding film. In this case, the photomask blank and the photomask may be a binary photomask blank and a binary photomask, respectively.

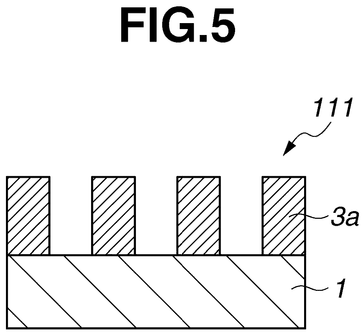

FIG. 5 is a cross-sectional view illustrating an example of first embodiment of a photomask of the invention. The photomask 111 includes, on a transparent substrate 1, a pattern (circuit pattern) of a film composed of a material containing chromium 3a that is formed in contact with the transparent substrate 1. The photomask of first embodiment can be manufactured from the photomask blank of first embodiment of or the photomask blank of third embodiment.

From the photomask blank of the invention, a photomask including a circuit pattern (photomask pattern) of the film composed of a material containing silicon can be manufactured. In the case of including the circuit pattern (photomask pattern) of the film composed of a material containing silicon, the film composed of a material containing silicon is preferably a phase shift film such as a halftone phase shift film, and the film composed of a material containing chromium is preferably a light-shielding film. In this case, the photomask blank and the photomask may be a phase shift mask blank such as a halftone phase shift mask blank, and a phase shift mask such as a halftone phase shift mask, respectively.

Particularly, from the photomask blank of the invention, a photomask in which a pattern (light-shielding portion (light-shielding pattern)) of the film composed of a material containing chromium is formed on the portion in the film composed of a material containing silicon that is located at the outer periphery portion of the transparent substrate, which is the portion not having the circuit pattern of the film composed of a material containing silicon (i.e., a portion outside of the region (effective region) having the circuit pattern), and in contact with the film composed of a material containing silicon can be manufactured.

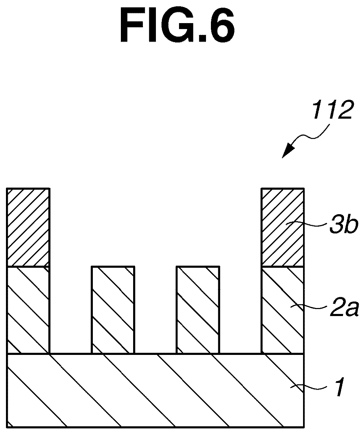

FIG. 6 is a cross-sectional view illustrating an example of second embodiment of a photomask of the invention. The photomask 112 includes, on a transparent substrate 1, a pattern of a film composed of a material containing silicon 2a that is formed in contact with the transparent substrate 1, and a pattern of a film composed of a material containing chromium 3b that is formed on the portion located at the outer periphery portion of the transparent substrate 1, which is the portion not having the circuit pattern of the film composed of a material containing silicon 2a, and in contact with the pattern of a film composed of a material containing silicon 2a. The photomask of second embodiment can be manufactured from the photomask blank of second embodiment or the photomask blank of fourth embodiment.

### [Method for Manufacturing Photomask]

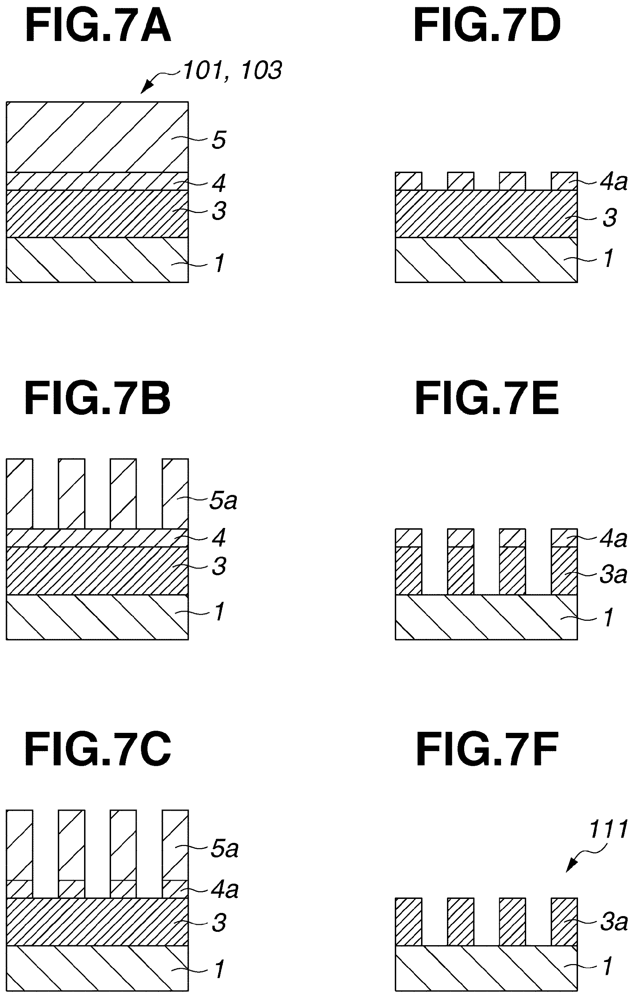

The photomask of first embodiment can be manufactured by, for example, the following method. FIG. 7A to 7F are cross-sectional views for explaining steps of manufacturing a reflective photomask of first embodiment from a reflective photomask blank of first embodiment or third embodiment.

In this case, when the photomask of first embodiment is used, initially, as shown in FIG. 7A, a first resist film 5 is formed in contact with the film composed of a material containing tantalum 4 of the photomask blank 101 at the side remote from the transparent substrate 1 (Step (A)). When the photomask blank of third embodiment is used, the step (A) may be substituted with a step (A0) of preparing a photomask blank 103.

The resist film formed in step (A) may be the same as the resist film in the photomask blank of third or fourth embodiment. The resist film formed in step (A) has a thickness of preferably not more than 120 nm, more preferably not more than 100 nm, even more preferably not more than 90 nm, further preferably not more than 70 nm, and is normally not less than 40 nm.

Next, as shown in FIG. 7B, a first resist film pattern 5a is formed by patterning the first resist film 5 (Step (B)).

Next, as shown in FIG. 7C, a pattern of the film composed of a material containing tantalum 4a is formed by patterning the film composed of a material containing tantalum 4 by dry etching using a fluorine-based gas, and the first resist film pattern 5a as an etching mask (Step (C)).

Next, as shown in FIG. 7D, the first resist film pattern 5a is removed (Step (D)). The step (D) may be performed after the following step (E).

Next, as shown in FIG. 7E, a pattern of the film composed of a material containing chromium 3a is formed by patterning the film composed of a material containing chromium 3 by dry etching using a chlorine-based gas containing oxygen, and the pattern of the film composed of a material containing tantalum 4a as an etching mask (Step (E)).

Next, as shown in FIG. 7F, the pattern of the film composed of a material containing tantalum 4a is removed by dry etching using a fluorine-based gas (Step (F1)). Accordingly, the photomask 111 of first embodiment can be obtained.

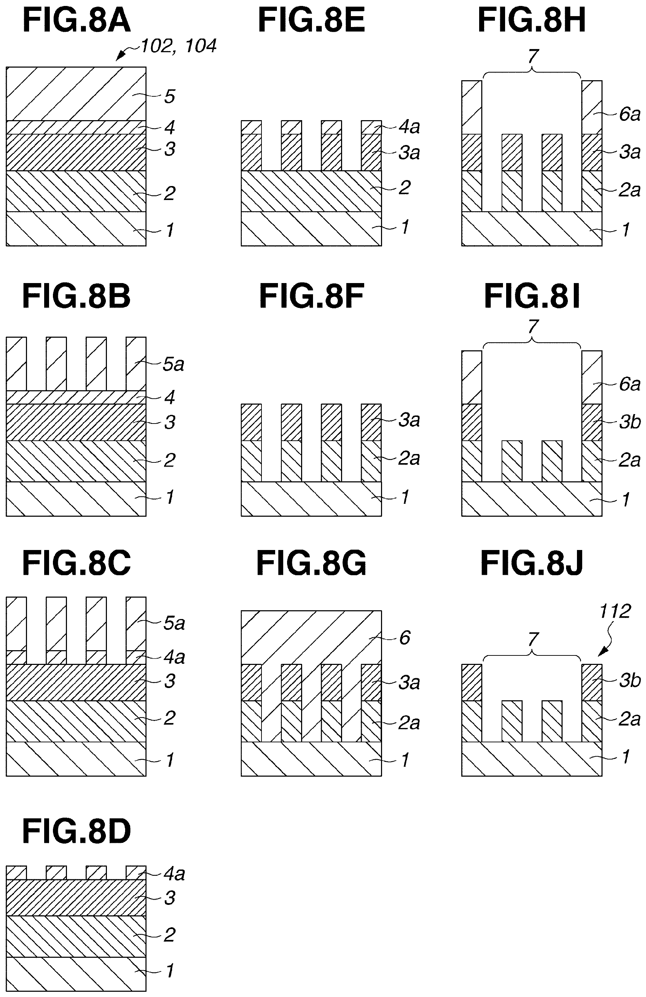

The photomask of second embodiment can be manufactured by, for example, the following method. FIGS. 8A to 8J are cross-sectional views for explaining steps of manufacturing a reflective photomask of second embodiment from a reflective photomask blank of second embodiment or fourth embodiment.

In this case, when the photomask of second embodiment is used, initially, as shown in FIG. 8A, a first resist film 5 is formed in contact with the film composed of a material containing tantalum 4 of the photomask blank 102 at the side remote from the transparent substrate 1 (Step (A)). When the photomask blank of fourth embodiment is used, the step (A) may be substituted with a step (A0) of preparing a photomask blank 104.

The resist film formed in step (A) may be the same as the resist film in the photomask blank of third or fourth embodiment. The resist film formed in step (A) has a thickness of preferably not more than 120 nm, more preferably not more than 100 nm, even more preferably not more than 90 nm, further preferably not more than 70 nm, and is normally not less than 40 nm.

Next, as shown in FIG. 8B, a first resist film pattern 5a is formed by patterning the first resist film 5 (Step (B)).

Next, as shown in FIG. 8C, a pattern of the film composed of a material containing tantalum 4a is formed by patterning the film composed of a material containing tantalum 4 by dry etching using a fluorine-based gas, and the first resist film pattern 5a as an etching mask (Step (C)).

Next, as shown in FIG. 8D, the first resist film pattern 5a is removed (Step (D)). The step (D) may be performed after the following step (E).

Next, as shown in FIG. 8E, a pattern of the film composed of a material containing chromium 3a is formed by patterning the film composed of a material containing chromium 3 by dry etching using a chlorine-based gas containing oxygen, and the pattern of the film composed of a material containing tantalum 4a as an etching mask (Step (E)).

Next, as shown in FIG. 8F, a pattern of the film composed of a material containing silicon 2a including a circuit pattern is formed by patterning the film composed of a material containing silicon 2 by dry etching using a fluorine-based gas, and the pattern of the film composed of a material containing chromium 3a as an etching mask, and the film composed of a material containing tantalum 4a is simultaneously removed (Step (F2)).

The step (A) to the step (F2) are conducted, then, the pattern of the film composed of a material containing chromium can be removed by dry etching using a chlorine-based gas containing oxygen to manufacture a photomask including a pattern (circuit pattern) of the film composed of a material containing silicon that is formed on and in contact with the transparent substrate. On the other hand, by further conducting the following step (G) to step (J), a photomask including a pattern of the film composed of a material containing chromium on the portion located at the outer periphery portion of the transparent substrate can be obtained.

After the step (F2), first, as shown in FIG. 8G, a second resist film 6 is formed in contact with the pattern of the film composed of a material containing chromium 3a and the exposed transparent substrate 1 at the side remote from the transparent substrate of the film composed of a material containing chromium 3a (Step (G)).

The resist film formed in step (G) may be the same as the resist film in the photomask blank of third or fourth embodiment, or a resist film for laser drawing or others may be used. The resist film formed in step (G) has a thickness of preferably not less than 200 nm, more preferably not less than 300 nm, and preferably not more than 1000 nm, more preferably not more than 800 nm.

Next, as shown in FIG. 8H, a second resist film pattern 6a is formed only at the outer periphery portion of the transparent substrate that is a region not having the circuit pattern (region other than effective region 7) by patterning the second resist film 6 (Step (H)).

Next, as shown in FIG. 8I, the pattern of the film composed of a material containing chromium at the portion other than the outer periphery (at the effective region 7) is removed by dry etching using a chlorine-based gas containing oxygen, and the second resist film pattern 6a as an etching mask so that the pattern of the film composed of the material containing chromium (light-shielding portion) 3b remains at the outer periphery of the transparent substrate.

Next, as shown in FIG. 8J, the second resist film pattern 6s is removed (Step (J)). Accordingly, the photomask 112 of second embodiment in which the pattern of the film composed of a material containing chromium (light-shielding portion) 3a is formed at the outer periphery, and the pattern of the film composed of a material containing chromium is not formed in the effective region 7 can be obtained.

The photomask of the invention is particularly effective in exposure to transfer the pattern to a photoresist film formed on a substrate to be processed by exposure light having a wavelength of not more than 250 nm, particularly not more than 200 nm, such as an ArF excimer laser (wavelength: 193 nm), F₂ laser (wavelength: 157 nm) and others in photolithography for forming a pattern having a half pitch of preferably not more than 50 nm, more preferably not more than 30 nm, even more preferably not more than 20 nm, further preferably not more than 10 nm to the substrate to be processed.

A photomask pattern can be exposed onto a photoresist film formed on a substrate to be processed, which is an exposure target of a photomask pattern, with using the photomask of the invention. In the pattern exposure method using the photomask of the invention, a photomask pattern can be transfer onto a photoresist film formed on a substrate to be processed by irradiating exposure light with using the photomask manufactured from the photomask blank. As the irradiation of the exposure light, exposure under dry conditions or immersion exposure may be applied, and the photomask is particularly suitable for use in exposure of a photomask pattern by immersion exposure using a wafer having a size of not less than 300 mm as a substrate to be processed.

### EXAMPLES

Examples of the invention are given below by way of illustration and not by way of limitation.

### Examples 1 to 10 and Comparative Examples 1 to 6

A photomask blank (halftone phase shift mask blank) in which a phase shift film (halftone phase shift film) as a film composed of a material containing silicon, a light-shielding film as a film composed of a material containing chromium, and a hard mask film as a film composed of a material containing tantalum are laminated in the order on a transparent substrate that was made of quartz and had dimensions of 152 mm square and about 6 mm thick was manufactured.

First, sputtering using a molybdenum target and a silicon target as targets, and argon gas and nitrogen gas as sputtering gases was performed with adjusting applied powers to the targets in an atmosphere of these gases to form the phase shift film (thickness: 70 nm) having a single-layer structure, as the film composed of a material containing silicon, that had a phase shift of 177 degrees and a transmittance of 6% (an optical density of 1.22), with respect to light having a wavelength of 193 nm, and was composed of MoSiN (Mo content: 3 at%, Si content; 52 at%, N content: 45 at%) on the transparent substrate.

Next, sputtering using a chromium target as a target, and argon gas, oxygen gas and carbon dioxide gas as sputtering gases was performed with adjusting an applied power to the target and adjusting flow rates of the sputtering gases to form the light-shielding film (thickness: 40 nm) having a single-layer structure, as the film composed of a material containing chromium, that had a transmittance of 1.4% (an optical density of 1.85), with respect to light having a wavelength of 193 nm, and was composed of CrOC (Cr content: 60 at%, O content; 20 at%, C content: 20 at%) on the phase shift film.

Next, in Examples 1 to 10 and Comparative Examples 3 to 6, puttering using a tantalum target as a target, and argon gas and oxygen gas, or argon gas, oxygen gas and nitrogen gas, as sputtering gases was performed with adjusting an applied power to the target and adjusting flow rates of the sputtering gases to form the hard mask film having a single-layer structure in the case of Examples 1 to 7 and Comparative Examples 3 to 6 or a two-layer structure of a first layer and a second layer in the case of Examples 8 to 10, as the film composed of a material containing tantalum, on the light-shielding film, thereby a photomask blank was obtained.

On the other hand, in Comparative Examples 1 and 2, puttering using a tantalum target as a target, and argon gas and oxygen gas as sputtering gases was performed with adjusting an applied power to the target and adjusting flow rates of the sputtering gases to form the hard mask film having a single-layer structure that was composed of silicon oxide (SiO) on the light-shielding film, thereby a photomask blank was obtained.

The composition and thickness of each layer of the hard mask film, and the thickness of the hard mask film are shown in Table 1. In Table 1, the second layer is a layer remotest from the transparent substrate. In Examples and Comparative Examples, the compositions of the film (layer) were measured by an X-ray photoelectron spectrometer. The thickness of the film (layer) was measured by an X-ray diffractometer.

**Table 1**

| | Hard Mask Film | | | | | | | |
|---|---|---|---|---|---|---|---|---|
| | Layer | Composition | Content [at%] | | | | Layer Thickness [nm] | Film Thickness [nm] |
| | | | Tantalum (Ta) | Silicon (Si) | Oxygen (O) | Nitrogen (N) | | |
| Example 1 | Single | TaON | 44 | 0 | 24 | 32 | 10 | 10 |
| Example 2 | Single | TaON | 44 | 0 | 24 | 32 | 15 | 15 |
| Example 3 | Single | TaON | 44 | 0 | 24 | 32 | 4 | 4 |
| Example 4 | Single | TaON | 60 | 0 | 10 | 30 | 10 | 10 |
| Example 5 | Single | TaON | 52 | 0 | 18 | 30 | 10 | 10 |
| Example 6 | Single | TaO | 58 | 0 | 42 | 0 | 10 | 10 |
| Example 7 | Single | TaO | 72 | 0 | 28 | 0 | 10 | 10 |
| Example 8 | Second | TaO | 58 | 0 | 42 | 0 | 2 | 10 |
| | First | TaON | 60 | 0 | 10 | 30 | 8 | |
| Example 9 | Second | TaO | 58 | 0 | 42 | 0 | 4 | 14 |
| | First | TaON | 60 | 0 | 10 | 30 | 10 | |
| Example 10 | Second | TaO | 58 | 0 | 42 | 0 | 4 | 14 |
| | First | TaN | 60 | 0 | 0 | 40 | 10 | |
| Comparative Example 1 | Single | SiO | 0 | 66 | 34 | 0 | 10 | 10 |
| Comparative Example 2 | Single | SiO | 0 | 66 | 34 | 0 | 10 | 10 |
| Comparative Example 3 | Single | TaO | 58 | 0 | 42 | 0 | 16 | 16 |
| Comparative Example 4 | Single | TaN | 70 | 0 | 0 | 30 | 10 | 10 |
| Comparative Example 5 | Single | TaN | 48 | 0 | 0 | 52 | 15 | 15 |
| Comparative Example 6 | Single | TaO | 39 | 0 | 61 | 0 | 10 | 10 |

### [Evaluation 1: Etching-clear-time of Dry Etching Using Chlorine-based Gas Containing Oxygen to Light-shielding Film]

With respect to an evaluation sample in which only a light-shielding film (a film composed of a material containing chromium) is formed on a transparent substrate by the same matter as in Example 1, a time (clear-time) for which the light-shielding film disappeared by dry etching using a chlorine-based dry containing oxygen was evaluated. The clear-time was a time for which an end point was detected (a time until the end point) in etching performed to the light-shielding film under the following conditions (Condition 1). As a result, the clear-time was 140 seconds, thus, the etching rate was 0.286 nm/s. [Conditions for Dry Etching Using Chlorine-based Gas Containing Oxygen (Condition 1)]
Apparatus: ICP (Inductively Coupled Plasma) System
Etching gas: Cl₂ gas and O₂ gas
Gas pressure: 3.0 mTorr (0.40 Pa)
ICP power: 350W

### [Evaluation 2: Reduced Amount of Hard Mask Film in Dry Etching Using Chlorine-based Gas Containing Oxygen to Light-shielding Film]

With respect to respective photomask blanks manufactured by the same matter as in Examples 1 to 10 and Comparative Examples 1 to 6, a reduced amount (thickness) of the hard mask film was evaluated by performing dry etching using a chlorine-based gas containing oxygen to the hard mask film (the film composed of a material containing tantalum, or the film composed of silicon oxide (SiO)) of the photomask blank under the Condition 1 described above for an etching time (560 seconds) in which a 300% of over-etching was added to the clear-time obtained in Evaluation 1 by dry etching using a chlorine-based gas containing oxygen to the light-shielding film (the film composed of a material containing chromium). The result is shown in Table 2.

As shown in Table 2, the film composed of a material containing tantalum of the photomask blank in Comparative Example 5 disappeared by exposure to dry etching using a chlorin-based gas containing oxygen for the etching time (560 seconds) in which a 300% of over-etching was added to the clear-time in the dry etching using a chlorin-based gas containing oxygen for the light-shielding film.

Further, an etching rate was calculated form the reduced amount of the hard mask film, and a ratio of the etching rate of the light-shielding film obtained in Evaluation 1 to the etching rate of the hard mask film was calculated. The result is shown in Table 2.

As shown in Table 2, the photomask blanks in Comparative Examples 4 and 5 had low ratios of the etching rate of the light-shielding film to the etching rate of the hard mask film. This is considered that this is because the films composed of a material containing tantalum of the photomask blanks in Comparative Example 4 and Comparative Example 5 did not contain oxygen, and had a high etching rate in dry etching using a chlorine-based gas containing oxygen, particularly, because the photomask blank of Comparative Example 5 has a higher nitrogen content, and has a further high etching rate in dry etching using a chlorine-based gas containing oxygen.

### [Evaluation 3: Etching-clear-time of Dry Etching Using Fluorine-based Gas to Hard Mask Film]

With respect to respective photomask blanks manufactured by the same matter as in Examples 1 to 10 and Comparative Examples 1 to 6, a time (clear-time) for which the hard mask film (the film composed of a material containing tantalum, or the film composed of silicon oxide (SiO)) disappeared by dry etching using a fluorine-based dry was evaluated. The clear-time was a time for which an end point was detected (a time until the end point) in etching performed to the hard mask film under the following conditions (Condition 2). The result is shown in Table 2.

### [Conditions for Dry Etching Using Fluorine-based Gas (Condition 2)]

Apparatus: ICP (Inductively Coupled Plasma) System
Etching gas: SF₆ gas and He gas
Gas pressure: 4.0 mTorr (0.53 Pa)
ICP power: 400W

As shown in Table 2, the film composed of a material containing tantalum of the photomask blank in Comparative Example 3 had a long clear-time. This is because the film composed of a material containing tantalum of the photomask blank in Comparative Example 3 was thick. Further, the film composed of a material containing tantalum of the photomask blank in Comparative Example 6 also had a long clear-time. It is considered that this is because the film composed of a material containing tantalum of the photomask blank in Comparative Example 6 had a high oxygen content.

### [Evaluation 4: Reduced Amount of Resist Film in Dry Etching Using Fluorine-based Gas to Hard Mask Film]

With respect to respective photomask blanks manufactured by the same matter as in Examples 1 to 10 and Comparative Examples 1 to 6, a reduced amount (thickness) of a resist film was evaluated in dry etching using a fluorine-based gas to the hard mask film (the film composed of a material containing tantalum, or the film composed of silicon oxide (SiO)).

First, a positive chemically amplified electron beam resist was spin-coated to form a resist film having a thickness of 100 nm on the hard mask film. Only in forming the resist film to the photomask blank in Comparative Example 1, the surface of the film formed of silicon oxide (SiO) was subjected to HMDS treatment, then the resist film was formed.

Next, a total of 20 isolated line patterns having dimensions of a long side of 100000 nm and a short side of 60 nm were drawn by an electron beam lithography equipment at a dose of 100 µC/cm². Next, heat treatment (PEB: Post Exposure Bake) was performed by a heat treatment equipment at 115 °C for 14 minutes. Next, puddle development was performed for 42 seconds to form a resist film pattern.

Next, the hard mask film of the photomask blank was subjected to dry etching using a fluorine-based gas with using the resist film pattern as an etching mask under Condition 2 described above for an etching time in which a 50% of over-etching was added to the clear-time obtained in Evaluation 3 by dry etching using a fluorine-based gas to the hard mask film, i.e., the etching time shown in Table 2, to form a pattern of the hard mask film. After that, a thickness of the resist film remained on the pattern of the hard mask film was measured, and the reduced thickness of the resist film was evaluated. The thickness of the resist film was measured by an atomic force microscope (AFM) within a range of a square area of 200 nm×200 nm as a measured range. The result is shown in Table 2 with the etching time.

Further, from the reduced amount of the resist film obtained, a thickness of the resist film that is necessary to remain a resist film having a thickness of 20 nm after performing dry etching using a fluorine-based gas to the resist film for an etching time in which a 50% of over-etching was added to the clear-time in dry etching using a fluorine-based gas to the hard mask film was calculated. The thickness s a minimum thickness of the resist film to perform dry etching using a fluorine-based gas. If the resist film is too thin, a fluorine-based plasma reaches to the hard mask film, thereby pinhole defects are formed, therefore, the remaining thickness of the resist film pattern after etching was set to a thickness of 20 nm. The result is shown in Table 2.

As shown in Table 2, in each of the photomask blanks in Comparative Example 3 and Comparative Example 6, the necessary minimum thickness of the resist film was thick because the film composed of a material containing tantalum had a long clear-time.

**Table 2**

| | Hard Mask Film | | | Resist Film | | | |
|---|---|---|---|---|---|---|---|
| | Evaluation 2 | | Evaluation 3 | Evaluation 4 | | | |
| | Reduced Amount [nm] | Ratio of Etching Rates | Clear-time [second] | HMDS Treatment | Etching Time [second] | Reduced Amount [nm] | Necessary Thickness [nm] |
| Example 1 | 0.23 | 694 | 20 | untreated | 30.0 | 33 | 53 |
| Example 2 | 0.23 | 694 | 30 | untreated | 45.0 | 50 | 70 |
| Example 3 | 0.23 | 694 | 8 | untreated | 12.0 | 13 | 33 |
| Example 4 | 0.23 | 694 | 15 | untreated | 22.5 | 25 | 45 |
| Example 5 | 0.23 | 694 | 17 | untreated | 25.5 | 29 | 49 |
| Example 6 | 0.23 | 694 | 23 | untreated | 34.5 | 38 | 58 |
| Example 7 | 0.23 | 694 | 21 | untreated | 31.5 | 34 | 54 |
| Example 8 | 0.23 | 694 | 18 | untreated | 27.0 | 30 | 50 |
| Example 9 | 0.23 | 694 | 22 | untreated | 33.0 | 36 | 56 |
| Example 10 | 0.23 | 694 | 18 | untreated | 27.0 | 30 | 50 |
| Comparative Example 1 | 0.32 | 496 | 9 | treated | 13.5 | 15 | 35 |
| Comparative Example 2 | 0.32 | 496 | 9 | untreated | 13.5 | 15 | 35 |
| Comparative Example 3 | 0.23 | 694 | 37 | untreated | 55.5 | 61 | 81 |
| Comparative Example 4 | 8.4 | 19 | 11 | untreated | 16.5 | 19 | 39 |
| Comparative Example 5 | 15.0 | 10 | 16 | untreated | 24.0 | 26 | 46 |
| Comparative Example 6 | 0.12 | 1323 | 43 | untreated | 64.5 | 71 | 91 |

### [Manufacture of Photomask]

A photomask (halftone phase shift mask) was manufactured by using the respective photomask blanks (halftone phase shift mask blanks) manufactured by the same manner as in Examples 1 to 10 and Comparative Examples 1 to 6.

First, a positive chemically amplified electron beam resist was spin-coated to form a first resist film on the hard mask film (the film composed of a material containing tantalum, or the film composed of silicon oxide (SiO)). As same as in Evaluation 4, only in forming the resist film to the photomask blank in Comparative Example 1, the surface of the film formed of silicon oxide (SiO) was subjected to HMDS treatment, then the resist film was formed (Step (A)).

In the manufacture of the photomask used in the evaluation of CD uniformity of the photomask (Evaluation 5) described later, a resist film having a thickness of 100 nm was formed in each of Examples 1 to 10 and Comparative Examples 1 to 6. In the manufacture of the photomask used in the evaluation of resolution limit of the photomask (Evaluation 6) and the evaluation of defect in the photomask (Evaluation 7) described later, a resist film having a thickness shown in Table 3 was formed in each. In Examples 1 to 10 and Comparative Examples 3, 5, and 6, the necessary thickness of the resist film, which is shown in Table 2, was not less than 40 nm, so, a resist film was formed at the necessary thickness of the resist film shown in Table 2. On the other hand, if the thickness of the resist film is less than 40 nm, the resist film having a uniform thickness may not be formed. In Comparative Examples 1, 2, and 4, the necessary thickness of the resist film, which is shown in Table 2, is less than 40 nm, so, a resist film was formed at a thickness of 40 nm.

Next, the first resist film was patterned to form a first resist film pattern (Step (B)). In manufacturing each of the photomask blanks used in Evaluations 5 to 7, a different resist film pattern was formed.

In manufacturing the photomask used in Evaluation 5, first, a total of 169 isolated space patterns having dimensions of a long side of 100000 nm and a short side of 200 nm were drawn in a square region of 12 cm×12 cm that is along the four sides of the main surface of the substrate and has the center at the intersection of the diagonals of the main surface of the substrate by an electron beam lithography equipment at a dose of 100 µC/cm². The isolated space patterns were arranged from one vertex of in the square region as an initial point, in 13 rows having a one-centimeter interval along one direction along one side of the square region and 13 rows having a one-centimeter interval along the other direction perpendicular to the one direction. Next, heat treatment (PEB: Post Exposure Bake) was performed by a heat treatment equipment at 115 °C for 14 minutes. Next, puddle development was performed for 60 seconds to form a resist film pattern.

In manufacturing the photomask used in Evaluation 6, first, as a test pattern corresponding to an assist pattern of a line pattern, a total of 200000 isolated line patterns having dimensions of a long side of 80 nm and a short side of from 20 nm to 80 nm which varies by 1 nm, i.e., having a different dimension in the short side were drawn by an electron beam lithography equipment at a dose of 100 µC/cm². Next, heat treatment (PEB: Post Exposure Bake) was performed by a heat treatment equipment at 115 °C for 14 minutes. Next, puddle development was performed for 60 seconds to form a resist film pattern.

In manufacturing the photomask used in Evaluation 7, first, line and space patterns having dimensions of a long side of 6 cm and a short side of 200 nm (the space and the line has a thickness of 200 nm, respectively) were drawn in the whole of a square region of 6 cm×6 cm that is along the four sides of the main surface of the substrate and has the center at the intersection of the diagonals of the main surface of the substrate by an electron beam lithography equipment at a dose of 100 µC/cm². Next, heat treatment (PEB: Post Exposure Bake) was performed by a heat treatment equipment at 115 °C for 14 minutes. Next, puddle development was performed for 60 seconds to form a resist film pattern.

Next, dry etching using a fluorine-based gas to the hard mask film of the photomask was performed to form a pattern of the hard mask film with using the resist film pattern as an etching mask under Condition 2 described above for an etching time in which a 50% of over-etching was added to the clear-time obtained in Evaluation 3 by dry etching using a fluorine-based gas to the hard mask film, i.e., the etching time shown in Table 2 (Step (C)).

Next, the resist film pattern was removed by washing with a sulfuric acid-hydrogen peroxide mixture (SPM) (a mixed solution of sulfuric acid and hydrogen peroxide solution in the volume ratio of sulfuric acid/hydrogen peroxide solution=3/1 (the same applies to the following sulfuric acid-hydrogen peroxide mixture) (Step (D)).

Next, dry etching using a chlorine-based gas containing oxygen was performed to form a pattern of the light-shielding film with using the pattern of the hard mask film as an etching mask under Condition 1 described above for an etching time (560 seconds) in which a 300% of over-etching was added to the clear-time obtained in Evaluation 1 by dry etching using a chlorine-based gas containing oxygen to the light-shielding film (the film composed of a material containing chromium) (Step (E)).

Next, dry etching using a fluorine-based gas was performed to form a pattern of the phase shift film including a circuit pattern with using the pattern of the light-shielding film as an etching mask under Condition 2 described above for an etching time (74 seconds) in which a about 3% of over-etching was added to the clear-time (72 seconds) in dry etching using a fluorine-based gas to the phase shift film (the film composed of a material containing silicon) by patterning the phase shift film, and the pattern of the hard mask film was simultaneously removed (Step (F2)).

Next, a resist film for laser drawing was spin-coated to form a second resist film (thickness: 360 nm) in contact with the pattern of the light-shielding film and the exposed transparent substrate at the side remote from the substrate of the pattern of the light-shielding film (Step (G)).

Next, the second resist film was patterned to form a second resist film pattern (Step (H)). First, the second resist film was patterned by a laser lithography equipment, and a pattern was drawn so that the second resist film did not remain in the region in which the circuit pattern had been formed (effective region), and the second resist film pattern remained only on the outer periphery of the transparent substrate, which is the region in which the circuit pattern had not been formed. Next, heat treatment (PEB: Post Exposure Bake) was performed by a heat treatment equipment at 110 °C for 20 minutes. Next, spray development was performed for 200 seconds to form a resist film pattern.

Next, dry etching using a chlorine-based gas containing oxygen was performed to remove the pattern of the light-shielding film other than the outer periphery portion so that the pattern of the light-shielding film was remained at the outer periphery portion with using the second resist film pattern as an etching mask under Condition 1 described above for an etching time (560 seconds) in which a 300% of over-etching was added to the clear-time obtained in Evaluation 1 by dry etching using a chlorine-based gas containing oxygen to the light-shielding film (Step (I)).

Next, the resist film pattern was removed by washing with a sulfuric acid-hydrogen peroxide mixture, then a photomask was obtained.

### [Evaluation 5: CD Uniformity of Photomask]

With respect to the obtained photomask (halftone phase shift mask), CD uniformity (uniformity of line width of patterns) was evaluated in film surface of the phase shift film (the film composed of a material containing silicon).

The line widths of 169 isolated space patterns in the phase shift film (the film composed of a material containing silicon) of the obtained photomask were measured by a critical dimension-scanning electron microscope (CD-SEM), and 3σ (three times of standard deviation) of the 169 of line widths was calculated. The results are shown in Table 3.

As shown in Table 3, the photomask in Comparative Example 4 and Comparative Example 5 had large 3σ, and low CD uniformity in the film surface of the phase shift film. It is considered that this is because the films composed of a material containing tantalum of the photomask blanks in Comparative Example 4 and Comparative Example 5 were tantalum nitride (TaN), by forming TaO unevenly or locally in the surface layer at the side remote from the substrate due to reaction with oxygen in the air, the etching rate in dry etching using a fluorine-based gas was nonuniform in the film surface and the CD uniformity in the film surface was reduced, thereby the CD uniformity in the film surface on the phase shift film was deteriorated.

### [Evaluation 6: Resolution Limit of Photomask]

With respect to the phase shift film (the film composed of a material containing silicon) of the obtained photomask (halftone phase shift mask), resolution limit was evaluated.

With respect to all of the 200000 isolated patterns in the phase shift film (the film composed of a material containing silicon) of the obtained photomask, pattern disappearance, pattern collapse, and pattern shape defects were evaluated by a visual inspection device, an isolated pattern having any of pattern disappearance, pattern collapse, and pattern shape defects detected by the visual inspection device was regarded as a defect, and the resolution limit was evaluated as the minimum dimension of the short side of the isolated pattern without the defect. The result is shown in Table 3.

As shown in Table 3, the photomask of Comparative Example 2 has a wide width in resolution limit (formable width of assist pattern is wide) and resolution is low. This is because the hard mask film of Comparative Example 2 is not a film composed of a material containing tantalum, and is a film composed of silicon oxide (SiO), and HMDS treatment is not performed, thereby having a less adhesion between the hard mask film and the resist film.

Further, as shown in Table 3, although not as much as in Comparative Example 2, the photomask of Comparative Example 3 has a wide width in resolution limit (formable width of assist pattern is wide) and resolution is low. It is considered that this is because the thick resist film was necessary according to the thick film composed of a material containing tantalum formed in Comparative Example 3, thus, in development process for forming the resist film pattern, the resist film pattern having a high aspect ratio collapsed due to impact of a developing solution or impact of pure water during rinsing.

Furthermore, as shown in Table 3, although not as much as in Comparative Example 2, the photomask of Comparative Example 6 also has a wide width in resolution limit (formable width of assist pattern is wide) and resolution is low. It is considered that this is because the thick resist film was necessary since the film composed of a material containing tantalum in Comparative Example 6 had a high oxygen content, and a low etching rate (a long clear-time) in dry etching using a fluorine-based gas, thus, in development process for forming the resist film pattern, the resist film pattern having a high aspect ratio collapsed due to impact of a developing solution or impact of pure water during rinsing.

### [Evaluation 7: Defect in Photomask]

With respect to the phase shift film (the film composed of a material containing silicon) of the obtained photomask (halftone phase shift mask), a defect in the photomask was evaluated.

As evaluation of appearance quality of the obtained photomask, a number of protrusion defects, chipping defects, and pinhole defects in the pattern of the phase shift film (the film composed of a material containing silicon), and pin dot defects on the transparent substrate and on the phase shift film were counted by a photomask appearance inspection device. The result is shown in Table 3.

As shown in Table 3, the photomask of Comparative Example 1 had a large number of defects. This is because the hard mask film in Comparative Example 1 was a film composed of silicon oxide (SiO) and was subjected to HMDS treatment, the resist residue on the film composed of silicon oxide (SiO) functioned as an etching mask when the film composed of silicon oxide (SiO) was etched, a portion of the film composed of silicon oxide (SiO) that should have been etched was unetched and remained, and eventually, the phase shift film at the position of the resist residue had beem unetched and remained, thereby forming defects, particularly pin dot defects on the transparent substrate or the phase shift film.

Further, as shown in Table 3, the photomask of Comparative Example 5 had a large number of defects. This is because the film (thickness: 15 nm) composed of a material containing tantalum in Comparative Example 5 was completely disappeared by dry etching using a chlorine-based gas containing oxygen (the reduced amount was 15 nm in Evaluation 2), as shown in Table 2, and the light-shielding film (the film composed of a material containing chromium) was etched in the exposed portion, thereby forming defects, particularly chipping defects or pinhole defects.

**Table 3**

| | Phase Shift Film | | | Thickness of Resist Film in Evaluations 6 and 7 |
|---|---|---|---|---|
| | Evaluation 5 | Evaluation 6 | Evaluation 7 | |
| | CD uniformity 3σ [nm] | Resolution Limit [nm] | Number of Defects [count] | |
| | | | | [nm] |
| Example 1 | 1.3 | 36 | 12 | 53 |
| Example 2 | 1.6 | 40 | 11 | 70 |
| Example 3 | 1.5 | 30 | 11 | 33 |
| Example 4 | 1.3 | 34 | 12 | 45 |
| Example 5 | 1.3 | 35 | 12 | 49 |
| Example 6 | 1.5 | 37 | 11 | 58 |
| Example 7 | 1.5 | 36 | 11 | 54 |
| Example 8 | 1.4 | 35 | 13 | 50 |
| Example 9 | 1.5 | 37 | 11 | 56 |
| Example 10 | 1.6 | 35 | 12 | 50 |
| Comparative Example 1 | 1.4 | 30 | 34 | 40 |
| Comparative Example 2 | 1.3 | 80 | 13 | 40 |
| Comparative Example 3 | 1.6 | 42 | 13 | 81 |
| Comparative Example 4 | 2.5 | 30 | 12 | 40 |
| Comparative Example 5 | 1.8 | 34 | 31 | 46 |
| Comparative Example 6 | 1.6 | 45 | 12 | 91 |

## Claims

1. A photomask blank comprising a transparent substrate, a film composed of a material comprising chromium that is formed on the transparent substrate, and a film composed of a material comprising tantalum that is formed on the film composed of a material comprising chromium, wherein
the film composed of a material comprising tantalum is constituted of a single layer or multiple layers,
the film composed of a material comprising tantalum has a thickness of not less than 0.5 nm and not more than 15 nm,
the material comprising tantalum comprises tantalum, and oxygen or oxygen and nitrogen, and is free of silicon,
the single layer and at least the layer remotest from the transparent substrate among the layers constituting the multiple layers are composed of a material comprising tantalum that has a tantalum content of not less than 40 at% and not more than 80 at%, an oxygen content of not less than 5 at% and not more than 50 at%, and a nitrogen content of not more than 50 at%, and
the layer remotest from the transparent substrate has a thickness of not less than 0.5 nm.

2. The photomask blank of claim 1 wherein when the film composed of a material comprising chromium and the film composed of a material comprising tantalum are subjected to dry etching using a chlorine-based gas comprising oxygen, a ratio of an etching rate of the film composed of a material comprising chromium to an etching rate of the film composed of a material comprising tantalum is not less than 50.

3. The photomask blank of claim 1 or 2 wherein the film composed of a material comprising chromium has a thickness of not less than 30 nm and not more than 80 nm.

4. The photomask blank of any one of claims 1 to 3 further comprising a film composed of a material comprising silicon between the transparent substrate and the film composed of a material comprising chromium.

5. The photomask blank of claim 4 wherein
the film composed of a material comprising silicon is a phase shift film,
the film composed of a material comprising chromium is a light-shielding film, and
the film composed of a material comprising tantalum is a hard mask film.

6. The photomask blank of claim 5 wherein the phase shift film has a phase shift of not less than 175 degrees and not more than 185 degrees, and a transmittance of not less than 6% and not more than 30%, with respect to exposure light, and a thickness of not less than 60 nm and not more than 85 nm.

7. The photomask blank of claim 6 wherein the light-shielding film and the phase shift film has a total optical density of not less than 3 with respect to the exposure light.

8. The photomask blank of any one of claims 1 to 7 further comprising a resist film that is in contact with the film composed of a material comprising tantalum at the side remote from the transparent substrate, and has a thickness of not less than 40 nm and not more than 120 nm.

9. A method for manufacturing a photomask comprising a circuit pattern of the film composed of a material comprising chromium from the photomask blank of any one of claims 1 to 3, wherein the method comprises the steps of:
(A) forming a first resist film that is in contact with the film composed of a material comprising tantalum at the side remote from the transparent substrate,
(B) patterning the first resist film to form a first resist film pattern,
(C) patterning the film composed of a material comprising tantalum to form a pattern of the film composed of a material comprising tantalum by dry etching using a fluorine-based gas, and the first resist film pattern as an etching mask,
(D) removing the first resist film pattern,
(E) patterning the film composed of a material comprising chromium to form a pattern of the film composed of a material comprising chromium by dry etching using a chlorine-based gas comprising oxygen, and the pattern of the film composed of a material comprising tantalum as an etching mask, and
(F1) removing the pattern of the film composed of a material comprising tantalum by dry etching using a fluorine-based gas.

10. A method for manufacturing a photomask comprising a circuit pattern of the film composed of a material comprising silicon from the photomask blank of any one of claims 4 to 7, wherein the method comprises the steps of:
(A) forming a first resist film that is in contact with the film composed of a material comprising tantalum at the side remote from the transparent substrate,
(B) patterning the first resist film to form a first resist film pattern,
(C) patterning the film composed of a material comprising tantalum to form a pattern of the film composed of a material comprising tantalum by dry etching using a fluorine-based gas, and the first resist film pattern as an etching mask,
(D) removing the first resist film pattern,
(E) patterning the film composed of a material comprising chromium to form a pattern of the film composed of a material comprising chromium by dry etching using a chlorine-based gas comprising oxygen, and the pattern of the film composed of a material comprising tantalum as an etching mask,
(F2) patterning the film composed of a material comprising silicon to form a pattern of the film composed of a material comprising silicon that comprises the circuit pattern by dry etching using a fluorine-based gas, and the film composed of a material comprising chromium as an etching mask, and simultaneously removing the film composed of a material comprising tantalum,
(G) forming a second resist film that in contact with the pattern of the film composed of a material comprising chromium and the exposed transparent substrate at the side remote from the transparent substrate of the film composed of a material comprising chromium,
(H) patterning the second resist film to form a second resist film pattern only at the outer periphery portion of the transparent substrate that is a region not comprising the circuit pattern,
(I) removing the pattern of the film composed of a material comprising chromium at the portion other than the outer periphery by dry etching using a chlorine-based gas comprising oxygen, and the second resist film pattern as an etching mask, so that the pattern of the film composed of the material comprising chromium remains at the outer periphery, and
(J) removing the second resist film pattern.

11. The method of claim 10 wherein
the film composed of a material comprising silicon is a phase shift film,
the film composed of a material comprising chromium is a light-shielding film, and
the film composed of a material comprising tantalum is a hard mask film.
